(19) Europäisches Patentamt
European Patent Office
Office européen des brevets

(11) **EP 4 496 459 A1**

(12) **EUROPEAN PATENT APPLICATION**

(43) Date of publication:
**22.01.2025 Bulletin 2025/04**

(21) Application number: **24189775.0**

(22) Date of filing: **19.07.2024**

(51) International Patent Classification (IPC):
**H10N 50/01** (2023.01)     H10B 61/00 (2023.01)

(52) Cooperative Patent Classification (CPC):
**H10N 50/01; H10B 61/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.07.2023 US 202363514876 P**

(71) Applicant: Everspin Technologies, Inc.
**Chandler, AZ 85226 (US)**

(72) Inventors:
• **NAGEL, Kerry Joseph**
  **Scottsdale, AZ 85266 (US)**
• **SHIMON**
  **120358 Singapore (SG)**
• **AGGARWAL, Sanjeev**
  **Scottsdale, AZ 85260 (US)**

(74) Representative: **Eisenführ Speiser**
**Patentanwälte Rechtsanwälte PartGmbB**
**Johannes-Brahms-Platz 1**
**20355 Hamburg (DE)**

(54) **MAGNETORESISTIVE DEVICES AND METHODS OF FABRICATING MAGNETORESISTIVE DEVICES**

(57)     A method of manufacturing a magnetoresistive device may comprise providing a magnetoresistive structure comprising a bottom electrode, a magnetoresistive stack, and a top electrode. The method may include removing at least a portion of the top electrode using a first etch, where the first etch is performed in the presence of a first gas mixture. Methods of manufacturing the magnetoresistive device may include removing at least a portion of the magnetoresistive stack and the bottom electrode using a second etch, wherein the second etch is performed in the presence of a second gas mixture. The first and second gas mixture may comprise a hydrocarbon including a carbon-carbon double bond or a carbon-carbon triple bond.

FIG. 1

EP 4 496 459 A1

**Description**

## CROSS REFERENCE TO RELATED APPLICATIONS

This application claims the benefit of priority from U.S. Provisional Application No. 63/514,876, filed on July 21, 2023, which is incorporated by reference in its entirety.

## TECHNICAL FIELD

The present disclosure relates to magnetoresistive stacks and methods of manufacturing magnetoresistive stacks.

## INTRODUCTION

There are many inventions described and illustrated herein, as well as many aspects and embodiments of those inventions. In one aspect, the present disclosure relates to magnetoresistive structures (for example, part of a magnetoresistive memory device, magnetoresistive sensor/transducer device, etc.) and methods of manufacturing the described magnetoresistive structures. For example, the disclosed structures may be related to magnetoresistive random access memory (MRAM) devices, magnetoresistive sensor/transducer devices, etc. To describe aspects of the disclosed devices and methods, exemplary magnetoresistive stack configurations are described. However, these are only exemplary. The disclosed devices can have many other stack configurations, and the disclosed methods can be applied to manufacture magnetoresistive devices having various suitable magnetoresistive stacks.

Briefly, a magnetoresistive stack used in a memory device (e.g., an MRAM device) includes at least one non-magnetic layer (for example, at least one dielectric layer or a non-magnetic yet electrically conductive layer) disposed between a fixed magnetic region (e.g., a fixed region) and a free magnetic region (e.g., a free region), each including one or more layers of ferromagnetic materials. Information may be stored in the magnetoresistive stack by switching, programming, and/or controlling the direction of magnetization vectors in the magnetic layer(s) of the free region. The direction of the magnetization vectors of the free region may be switched and/or programmed (for example, through spin transfer torque (STT)) by application of a write signal (e.g., one or more current pulses) adjacent to, or through, the magnetoresistive memory stack. In contrast, the magnetization vectors in the magnetic layers of a fixed region are magnetically fixed in a predetermined direction. When the magnetization vectors of the free region adjacent to the non-magnetic layer are in the same direction as the magnetization vectors of the fixed region adjacent to the non-magnetic layer, the magnetoresistive memory stack has a first magnetic state. Conversely, when the magnetization vectors of the free region adjacent to the non-magnetic layer are opposite the direction of the magnetization vectors of the fixed region adjacent to the non-magnetic layer, the magnetoresistive memory stack has a second magnetic state. Together, the magnetic regions on either side of the non-magnetic layer form a magnetic tunnel junction (MTJ) when the non-magnetic layer is a dielectric material. The MTJ has different electrical resistances in the first and second magnetic states. For example, a resistance of the second magnetic state may be relatively higher than a resistance of the first magnetic state. The magnetic state of the magnetoresistive memory stack is determined or read based on the resistance of the stack in response to a read current applied, for example, through the magnetoresistive stack.

## BRIEF DESCRIPTION OF THE DRAWINGS

Embodiments of the present disclosure may be implemented in connection with aspects illustrated in the attached drawings. These drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

For simplicity and clarity of illustration, the figures depict the general structure and/or manner of construction of the various embodiments described herein. For ease of illustration, the figures depict the different layers/regions of the illustrated magnetoresistive stacks as having a uniform thickness and well-defined boundaries with straight edges. However, a person skilled in the art would recognize that, in reality, the different layers typically have a non-uniform thickness. And, at the interface between adjacent layers, the materials of these layers may alloy together, or migrate into one or the other material, making their boundaries ill-defined. Descriptions and details of well-known features (e.g., interconnects, etc.) and techniques may be omitted to avoid obscuring other features. Elements in the figures are not necessarily drawn to scale. The dimensions of some features may be exaggerated relative to other features to improve understanding of the exemplary embodiments. Cross-sectional views are simplifications provided to help illustrate the relative positioning of various regions/layers and describe various processing steps. One skilled in the art would appreciate that the cross-sectional views are not drawn to scale and should not be viewed as representing proportional relationships between different regions/layers. Moreover, while certain regions/layers and features are illustrated with straight 90-degree edges, in actuality or practice such regions/layers may be more "rounded" and/or gradually sloping.

Further, one skilled in the art would understand that, although multiple layers with distinct interfaces are illustrated in the figures, in some cases, over time and/or exposure to high temperatures, materials of some of the layers may migrate into or interact with materials of other layers to present a more diffuse interface between these layers. It should be noted that, even if it is not specifically mentioned, aspects described with reference to one embodiment may also be applicable to, and may be used with, other embodiments.

Moreover, there are many embodiments described and illustrated herein. The present disclosure is neither limited to any single aspect nor embodiment thereof, nor to any combinations and/or permutations of such aspects and/or embodiments. Moreover, each aspect of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein. Notably, an embodiment or implementation described herein as "exemplary" is not to be construed as preferred or advantageous, for example, over other embodiments or implementations; rather, it is intended to reflect or indicate that the embodiment(s) is/are "example" embodiment(s). Further, even though the figures and this written disclosure appear to describe the magnetoresistive stacks of the disclosed magnetoresistive devices in a particular order of construction (e.g., from bottom to top), it is understood that the depicted magnetoresistive stacks may have a different order (e.g., the opposite order (i.e., from top to bottom)).

FIGs. 1, 2A-2E, and 3A-3E illustrate cross-sectional views depicting various regions of an exemplary magnetoresistive structure, according to one or more embodiments of the present disclosure;

FIG. 4 illustrates a cross-sectional view depicting various regions of adjacent exemplary magnetoresistive structures, according to one or more embodiments of the present disclosure;

FIGs. 5A and 5B illustrate cross-sectional views depicting various regions of an exemplary magnetoresistive structure, according to one or more embodiments of the present disclosure;

FIGs. 6A and 6B are schematic illustrations of exemplary magnetoresistive structure integration schemes, according to one or more embodiments of the present disclosure; and

FIG. 7 is a flowchart illustrating an exemplary fabrication process of a magnetoresistive structure, according to one or more embodiments of the present disclosure.

Again, there are many embodiments described and illustrated herein. The present disclosure is not limited to any single aspect or embodiment thereof, nor is it limited to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

## DETAILED DESCRIPTION

Magnetoresistive devices, such as magnetic sensors, magnetic transducers, and magnetic memory cells, include magnetic materials where the magnetic moments of those materials can be varied to provide sensing information or store data. Magnetoresistive devices, spin electronic devices, and spintronic devices are synonymous terms for devices that make use of effects predominantly caused by electron spin. Magnetoresistive memory devices are used in numerous information devices to provide non-volatile, reliable, radiation resistant, and high-density data storage and retrieval. The numerous magnetoresistive devices may include, but are not limited to, Magnetoresistive Random Access Memory (MRAM), magnetic sensors, and read/write heads for disk drives.

Manufacturing magnetoresistive devices includes a sequence of processing steps where multiple layers of materials are deposited and patterned to form a magnetoresistive stack and the electrodes used to provide electrical connections to the magnetoresistive stack. The magnetoresistive stack includes the various regions or layers that make up free and fixed regions of the device as well as one or more intermediate regions (e.g., dielectric layers) that separate these free and fixed regions, and in some cases, provide at least one tunnel junction for the device. In many instances, the layers of material in the magnetoresistive stack may be relatively very thin, e.g., on the order of a few or tens of angstroms.

In some applications, magnetoresistive devices may be included on the same integrated circuit with additional surrounding circuitry. For example, magnetoresistive devices (MRAMs, magnetic sensors, magnetic transducers, etc.) may be included on an integrated circuit with a microcontroller or other processing circuitry configured to utilize the information collected by, or stored in, the magnetoresistive devices.

An integrated circuit device may include conductive layers that are deposited and patterned to form connective traces, circuits, magnetoresistive devices, and interlayer connections. Circuits, magnetoresistive devices, and other components of the integrated circuit device (e.g., transistors, capacitors, diodes, etc.) may be coupled using structures within metal layers and via layers. To increase capacity and/or performance of the integrated circuit device, it may be desirable to create integrated circuit devices with a high density of components.

High-density integrated circuit devices may include multiple vertically stacked levels of interconnects (e.g., metal layers and/or vias). Each of the metal layers may be separated from other metal layers by one or more dielectric materials (e.g., interlayer dielectrics) that electrically isolate the metal layers from each other. Vias between the different metal layers may provide electrical connection between the different metal layers. A via may provide electrical connectivity between two adjacent metal layers, and may include electrically conductive material disposed in an aperture of the interlayer dielectric between two metal layers. For example, vias may connect features within a first metal layer (e.g., M1 layer) to the features within a second metal layer (e.g., M2 layer).

Magnetoresistive devices may include a plurality of magnetoresistive structures embedded therein (e.g., between metal layers and/or vias). A magnetoresistive structure may include a plurality of magnetic material layers (or regions) separated by one or more intermediate regions.

The multiple layers of materials that may form different regions of a magnetoresistive devices are described in references incorporated herein, and therefore are not discussed in detail herein. Possible compositions and/or layers that may constitute the exemplary magnetoresistive device are described in, for example, U.S. Pat. Nos. 8,686,484; 8,747,680; 9,023,219; 9,136,464; 9,412,786; 9,419,208; 9,722,174; 10,461,251; 10,483,460; 10,700,268; and 10,847,711, each of which is incorporated by reference in its entirety.

The present disclosure generally relates to magnetoresistive devices having a magnetoresistive stack or structure (for example, part of a magnetoresistive memory device, magnetoresistive sensor/transducer device, etc.) and methods of manufacturing the described magnetoresistive devices. For example, present embodiments describe improved methods for manufacturing magnetoresistive devices (e.g., magnetoresistive devices within an integrated circuit device). The improved methods may include improved etching steps with improved etching chemistry. As described herein, the improved methods may result in magnetoresistive devices with improved dimensions and physical properties, compared to magnetoresistive devices manufactured using conventional methods.

As known to those of ordinary skill in the art, magnetoresistive devices may be manufactured by depositing layers corresponding to constituent regions of the magnetoresistive devices. After the layers are deposited, individual bits or magnetoresistive stacks may be etched or otherwise formed from the deposited layers.

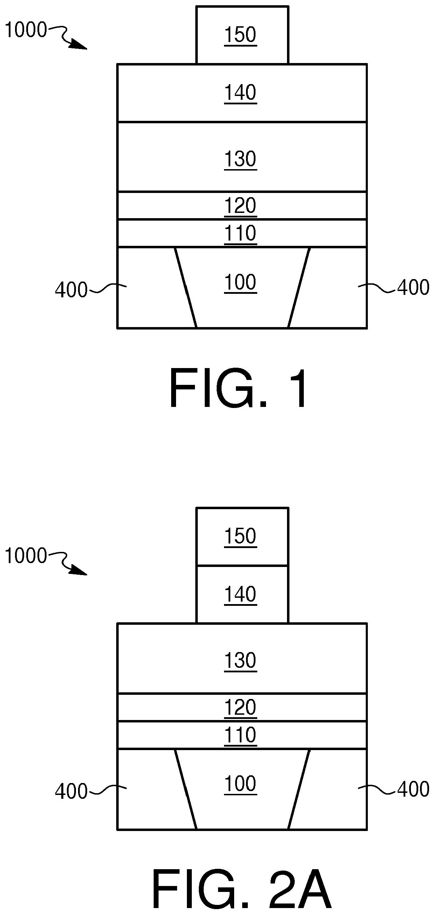

Referring to FIG. 1, an exemplary unetched magnetoresistive structure 1000 is shown. The exemplary unetched magnetoresistive structure 1000 may include the layers of a magnetoresistive stack prior to the individual stack being etched (e.g., after the layers are deposited). One or more interlayer dielectric layers (ILD) 400 may fill the space between the metal layers (not pictured) and vias 100. ILD 400 may be deposited over the features of one or more metal layers. ILD 400 may include a conventional ILD material (such as, for example, TEOS, $SiO_2$, etc.) and/or a low-k ILD material (such as, for example, carbon doped $SiO_2$ (SiOC), carbon doped oxide (CDO), organosilicate glass (OSG), spin-on organics, etc.). Although a single ILD 400 is illustrated in drawings, this is only exemplary. In some embodiments, multiple ILDs 400 may be used. For example, some regions of the device (e.g., metal layers or portions of metal layers) may use one type of ILD 400 (e.g., a conventional ILD) and other regions of the device may use another types of ILD 400 (e.g., a low-k ILD). See, for example, U.S. Patent No. 10,950,657, which is incorporated by reference in its entirety.

Still referring to FIG. 1, layers of the magnetoresistive structure 1000 may be formed above via 100. For example, layers corresponding to bottom electrode 110, layers corresponding to a magnetoresistive stack 120 (e.g., one or more fixed regions, a free region, and/or an intermediate region between the free region and one or more fixed regions), and/or layers corresponding to a top electrode 130 may be deposited above ILD 400 and via 100.

After the constituent regions of unetched magnetoresistive structure 1000 are formed, individual magnetoresistive structures (e.g., magnetoresistive structures 1100, 1200) may be formed from the regions. For example, one or more etching steps (e.g., chemical etching and/or physical etching) may be performed on the regions to form magnetoresistive structures. After the layers constituting the bottom electrode 110, the magnetoresistive stack 120, and/or the top electrode 130 are formed, a hardmask 140 and a photoresist 150 may be deposited above the layers of the bottom electrode 110, magnetoresistive stack 120, and/or top electrode 130. As known to those of ordinary skill in the art the photoresist 150 may be selectively exposed to pattern of electromagnetic radiation, to imprint the pattern of the radiation to the photoresist 150. The patterned photoresist 150 may then be used to transfer the pattern to the hardmask 140. For example, referring to FIG. 1, the hardmask 140 and the photoresist 150 may be deposited above top electrode 130. The photoresist 150 may be patterned such that a first portion of hardmask 140 is below (covered by) a portion of photoresist 150 and a second portion of hardmask 140 is exposed (i.e., not below or covered by a portion of photoresist 150).

After the hardmask 140 is patterned, it may be used as a template to etch layers below the hardmask (e.g., layers corresponding to bottom electrode 110, layers corresponding to a magnetoresistive stack 120 (e.g., one or more fixed regions, a free region, and/or an intermediate region between the free region and one or more fixed regions), and/or layers corresponding to a top electrode 130). For example, the patterned hardmask 140 may be used as a template to etch one or more of a top electrode, a magnetoresistive stack, and/or a bottom electrode. After the photoresist is stripped from the magnetoresistive device, additional etching steps may form the magnetoresistive structure 1100, 1200 (e.g., a bit of a magnetoresistive memory device).

One example of a conventional method of forming magnetoresistive structures 1100, 1200 from unetched magnetoresistive structures 1000 is shown in FIGs. 2A-2E, and described herein. Referring to FIG. 2A, the pattern of photoresist 150 may be transferred to hardmask 140, to form a patterned hardmask 140 above top electrode 130.

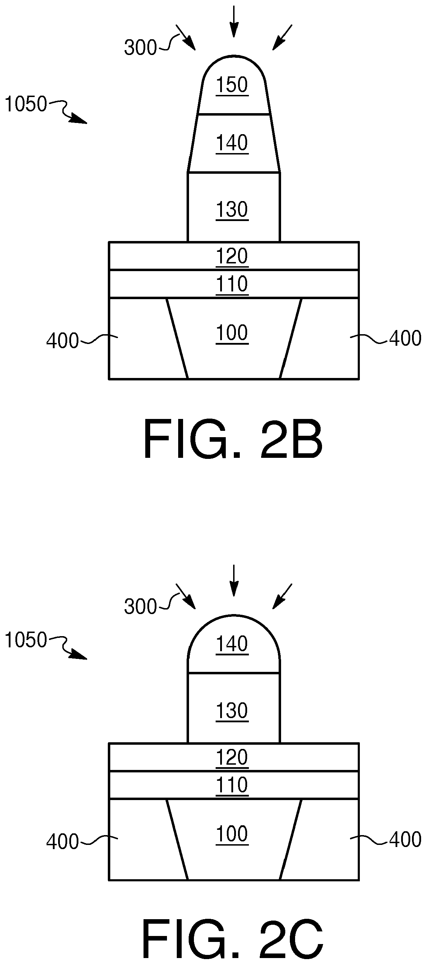

Referring to FIG. 2B, the patterned hardmask 140 may be used as a template for a first etch. The first etch may include etching a portion of the layer or layers corresponding to top electrode 130 to form a partially etched structure 1050. For example, reactive ion etching (RIE) and/or ion-beam etching (IBE) may be used to remove a portion of the layer or layers corresponding to top electrode 130. The first etch may terminate at the interface of the layer or layers that form top electrode 130 and the layer or layers that form the magnetoresistive stack 120. In some embodiments, the first etch may terminate within a layer of magnetoresistive stack 120. The RIE or IBE used in the first etch may erode hardmask 140. Examples of the direction of hardmask erosion are shown by arrows 300. As a result of erosion, a top surface of hardmask 140 may become sloped. In addition or alternatively, side walls of hardmask 140 may become sloped and/or curved as a result of erosion.

Referring to FIG. 2C, the photoresist 150 may be stripped and/or removed from a partially etched magnetoresistive structure 1050. For example, the photoresist 150 may be stripped after the first etch. Stripping the photoresist 150 may erode hardmask 140. Examples of the direction of hardmask erosion are shown by arrows 300. As a result of erosion, a slope of the top surface and/or the sidewalls of hardmask 140 may increase.

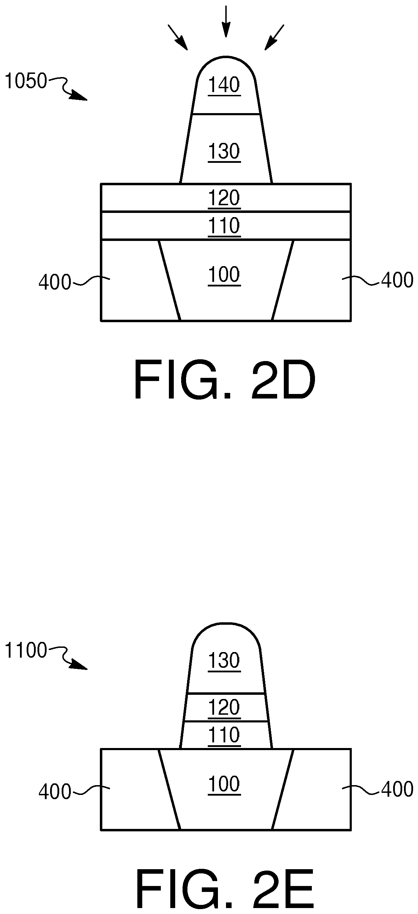

After the photoresist 150 is stripped, additional etching (e.g., RIE or IBE) may be used to clean redeposited material from the partially etched structure 1050. The additional etching may erode hardmask 140. An example of a partially etched structure 1050 after additional etching is shown in FIG. 2D. Directions in which hardmask 140 may erode are shown by arrows 300. As a result of erosion, a slope of the top surface and/or the sidewalls of hardmask 140 may increase. In addition or alternatively, the area of the layers of magnetoresistive stack 120 that are covered by hardmask 140 and/or top electrode 130 may decrease.

Referring to FIG. 2E, a second etch may be used to remove a portion of the layer or layers corresponding to magnetoresistive stack 120 and/or bottom electrode 110. For example, reactive ion etching and/or ion-beam etching may be used to remove a portion of the layer or layers corresponding to magnetoresistive stack 120 and bottom electrode 110 to form a magnetoresistive structure 1100. The second etch may terminate at an interface of the layer or layers that form bottom electrode 110 and the layer or layers that form via 100. The second etch may terminate at an interface of the layer or layers that form bottom electrode 110 and ILD 400. In some embodiments, the first etch may terminate within a layer of via 100 or ILD 400. Hardmask 140 may be used as a template for the second etch. In some embodiments, top electrode 130 is used as a template for the second etch.

As described herein, the etching processes used in the conventional formation of the magnetoresistive device may result in erosion of the hardmask 140. The use of the eroded hardmask 140 as an etching template can result in tapered and short MTJ bits. As described herein, the tapered profile resulting from these conventional etching processes may result in other disadvantageous structural characteristics of the magnetoresistive device.

Methods of the present disclosure may include the use of a hydrocarbon gas during etching (e.g., a first etch, a second etch, and/or additional etching), wherein the hydrocarbon gas includes a carbon-carbon double bond or a carbon-carbon triple bond. For example, the hydrocarbon gas may include ethylene ($C_2H_4$), ethyne, ($C_2H_2$), propylene ($C_3H_6$), propyne ($C_3H_4$), butene ($C_4H_8$), butyne ($C_4H_6$), any other hydrocarbon gas having the formula $C_xH_y$ and including a carbon-carbon double bond or a carbon-carbon triple bond, or a combination thereof. The use of the hydrocarbon may increase the polymerization of the hardmask 140 during etching, which may result in less erosion of the hardmask 140 during etching. Embodiments of the present disclosure may be used in conjunction with various hardmask 140 compositions, such as, for example, silicon based hardmasks 140 (e.g., silicon dioxide ($SiO_2$), organosilicate glasses including carbon doped $SiO_2$ or spin on glass, SiCOH and SiCNH dielectrics, tetraethyl orthosilicate (TEOS)) and/or spin on carbon based hardmasks 140.

By etching in the presence of a hydrocarbon gas including a carbon-carbon double bond or a carbon-carbon triple bond, polymerization of the hardmask 140 is increased, erosion of the hardmask 140 is reduced, and more of the hardmask 140 will remain for subsequent etching steps. Etching in the presence of a hydrocarbon gas may include a chemical etch (e.g., RIE), a physical etch (e.g., IBE), or both. The hydrocarbon gas may be included with one or more inert gases (e.g., argon, nitrogen, etc.) that are used as carrier gases during the etching processes. In addition or alternatively, the hydrocarbon gas may be included with one or more reactive gases used in a reactive ion etch (e.g., Ar, $O_2$, $CF_4$, $CH_4$, one or more fluorocarbons having the formula $C_xF_y$, $CHF_3$, $Cl_2$, $H_2O$, $H_2$, $N_2$, $NH_3$, $SF_6$, or a combination thereof). The hydrocarbon gas may be incorporated with a carrier gas or reactive gas at a molar ratio of approximately 1:1 to a molar ratio of approximately 1:10. In embodiments where a relatively heavy hydrocarbon is used, the hydrocarbon may be incorporated at a lower molar ratio, compared to lighter hydrocarbons. In embodiments where a hydrocarbon comprising a carbon-carbon triple bond is used, the hydrocarbon gas may be incorporated at a lower molar ratio, compared to embodiments including a hydrocarbon comprising a carbon-carbon double bond.

Embodiments of the present disclosure also allow for the tuning of the etch process to achieve a desired polymerization/erosion rate of the hardmask 140. For example, the bias power of the etch may be increased to decrease the rate of hardmask 140 polymerization. In addition or alternatively, decreasing the etch angle may increase polymerization of the hardmask 140 at the top of the bit and decrease polymerization of the hardmask 140 on the sidewalls of the bit. Increasing the etch angle may decrease polymerization of the hardmask 140 at the top of the bit and increase polymerization of the hardmask 140 on the sidewalls of the bit. As used herein, etch angle may be defined as the angle formed between the incident of the etch and the substrate upon which the magnetoresistive devices are formed.

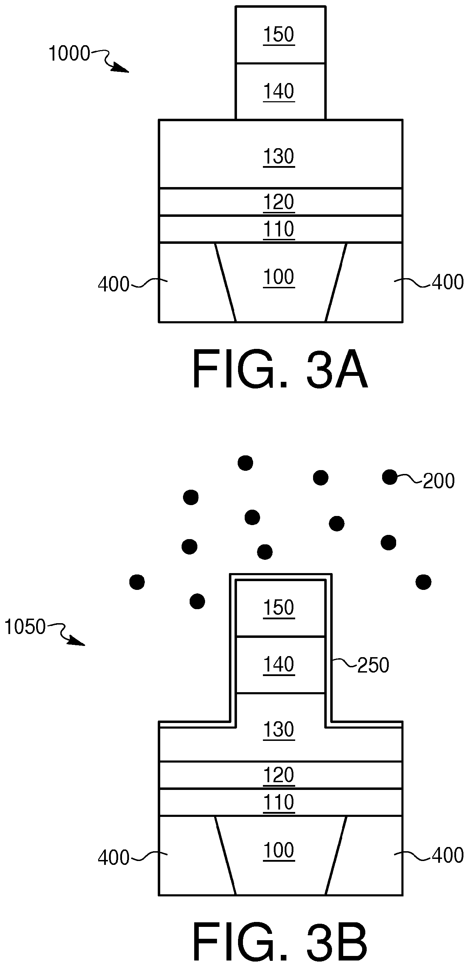

One example of a method of forming magnetoresistive structures 1200 from unetched magnetoresistive structures 1000, including etching in the presence of a hydrocarbon with a carbon-carbon double bond or a carbon-carbon triple bond, is shown in FIGs. 3A-3E, and described herein. Referring to FIG. 3A, the pattern of photoresist 150 may be transferred to hardmask 140, to form a patterned hardmask 140 above top electrode 130.

Referring to FIG. 3B, the patterned hardmask 140 may be used as a template for a first etch. The first etch may include etching a portion of the layer or layers corresponding to top electrode 130 to form a partially etched structure 1050. For example, reactive ion etching (RIE) and/or ion-beam etching (IBE) may be used to remove a portion of the layer or layers corresponding to top electrode 130. The first etch may terminate at the interface of the layer or layers that form top electrode 130 and the layer or layers that form the magnetoresistive stack 120. In some embodiments, the first etch may terminate within a layer of magnetoresistive stack 120.

The first etch may include a RIE and/or an IBE in the presence of a hydrocarbon gas 200 including a carbon-carbon double bond or a carbon-carbon triple bond. The presence of the hydrocarbon gas 200 may induce the formation of a polymerization layer 250 on partially etched magnetoresistive structure 1050. Polymerization layer 250 may include a polymer formed from the hydrocarbon gas 200. Polymerization layer 250 may prevent, reduce, or otherwise mitigate hardmask 140 erosion during the first etch. Polymerization layer 250 may form on one or more surfaces created during the first etch. For example, polymerization layer may form on a top surface of the photoresist 150, a top surface of one or more layers corresponding to top electrode 130, one or more sidewalls of top electrode 130, one or more sidewalls of hardmask 140, and/or one or more sidewalls of photoresist 150.

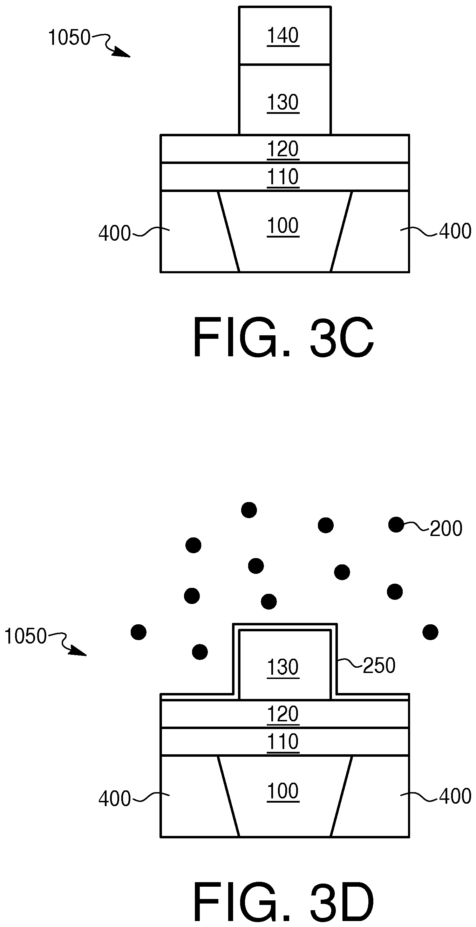

Referring to FIG. 3C, the photoresist 150 may be stripped and/or removed from a partially etched magnetoresistive structure 1050. For example, the photoresist 150 may be stripped after the first etch. After the photoresist 150 is stripped, additional etching (e.g., RIE or IBE) may be used to clean redeposited material from the partially etched structure 1050. Additional etching may include the cleaning of redeposited material from one or more sidewalls of partially etched structure 1050. Additional etching may occur in the presence of a hydrocarbon gas 200 including a carbon-carbon double bond or a carbon-carbon triple bond. The presence of the hydrocarbon gas 200 may induce the formation of a polymerization layer 250 on partially etched magnetoresistive structure 1050. Polymerization layer 250 may include a polymer formed from the hydrocarbon gas 200. Polymerization layer 250 may prevent, reduce, or otherwise mitigate hardmask 140 erosion during the additional etching. Polymerization layer 250 may form on one or more surfaces that are etched during the additional etching. For example, polymerization layer may form on a top surface of one or more layers corresponding to top electrode 130, one or more sidewalls of top electrode 130, and/or one or more layer corresponding to magnetoresistive stack 120. An example of a partially etched structure 1050 during additional etching in the presence of hydrocarbon gas 200 is shown in FIG. 3D.

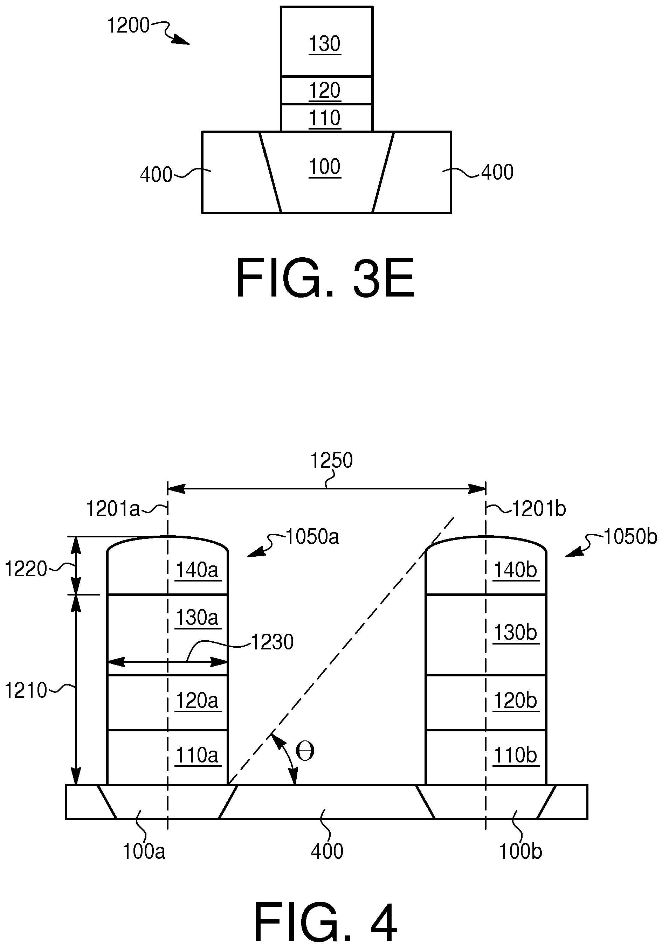

Referring to FIG. 3E, a second etch may be used to remove a portion of the layer or layers corresponding to magnetoresistive stack 120 and/or bottom electrode 110. For example, reactive ion etching and/or ion-beam etching may be used to remove a portion of the layer or layers corresponding to magnetoresistive stack 120 and bottom electrode 110 to form a magnetoresistive structure 1200. The second etch may terminate at an interface of the layer or layers that form bottom electrode 110 and the layer or layers that form via 100. The second etch may terminate at an interface of the layer or layers that form bottom electrode 110 and ILD 400. In some embodiments, the first etch may terminate within a layer of via 100 or ILD 400. Hardmask 140 may be used as a template for the second etch. In some embodiments, top electrode 130 is used as a template for the second etch.

The second etch may include a RIE and/or an IBE in the presence of a hydrocarbon gas 200 including a carbon-carbon double bond or a carbon-carbon triple bond. The presence of the hydrocarbon gas 200 may induce the formation of a polymerization layer 250 on partially etched magnetoresistive structure 1050. Polymerization layer 250 may include a polymer formed from the hydrocarbon gas 200. Polymerization layer 250 may prevent, reduce, or otherwise mitigate hardmask 140 erosion during the second etch. Polymerization layer 250 may form on one or more surfaces created during the first etch. For example, polymerization layer may form on a top surface of one or more layers corresponding to top electrode 130, one or more sidewalls of top electrode 130, a top surface of a constituent layer of magnetoresistive stack 120, a top surface of a constituent layer of bottom electrode 110, one or more sidewalls of magnetoresistive stack 120, and/or one or more sidewalls of bottom electrode 110.

As described herein, methods of the present disclosure allow for the preservation of the hardmask 140 during etching. For example, methods of the present disclosure may reduce, prevent, or otherwise mitigate hardmask 140 erosion. The preservation of the hardmask 140 allows for a smaller thickness of hardmask 140 to be used in the manufacture of the magnetoresistive devices, compared to conventional manufacturing techniques. The smaller thickness of hardmask 140 allows for increased availability of the sidewalls of adjacent bits. The increased availability of the sidewalls allows for sidewall cleaning using a 45° ion-beam etch at reduced pitches.

An example of a first partially etched magnetoresistive structure 1050a and an adjacent second partially etched magnetoresistive structure 1050b is shown in FIG. 4. The first partially etched magnetoresistive structure 1050a is formed above a first via 100a, and includes a bottom electrode 110a, a magnetoresistive stack 120a, a top electrode 130a. The second partially etched magnetoresistive structure 1050b is formed above a second via 100b, and includes a bottom electrode 110b, a magnetoresistive stack 120b, and a top electrode 130b. The first via 100a is separated from the second via 100b by ILD 400. A first portion of a patterned hardmask 140a is above the first partially etched magnetoresistive structure 1050a and a second portion of the patterned hardmask 140b is above the second partially etched magnetoresistive structure. A distance between the first partially etched magnetoresistive structure 1050a and an adjacent partially etched magnetoresistive structure 1050 (e.g., second partially etched magnetoresistive structure 1050b) may be referred to as a pitch 1250. The pitch 1250 may be measured from a central axis of a magnetoresistive structure (e.g., central axis 1201a of first partially etched magnetoresistive structure 1050a) to a central axis of an adjacent magnetoresistive structure (e.g., central axis 1201b of the second partially etched magnetoresistive structure 1050b). Angle θ represents the minimum angle that may be used to clean the sidewalls of a magnetoresistive structure (e.g., first partially etched magnetoresistive structure 1050a). Angle θ is dependent on the pitch 1250, a height 1210 of the magnetoresistive structure, a thickness 1220 of hardmask 140, and a width 1230 of the magnetoresistive structure. Conventional methods of manufacturing magnetoresistive devices including an increased thickness 1220 of hardmask 140 include a greater minimum etch angle θ compared to methods of the present disclosure including a hydrocarbon gas 200 that reduces, prevents, or otherwise mitigates erosion of hardmask 140. The relative relationship of minimum etch angle θ, pitch 1250, height 1210 of the magnetoresistive structure, width 1230 of the magnetoresistive structure, and thickness 1220 of hardmask 140 may be described by Equation 1.

$$\tan \theta = \frac{h+t}{p-w} \qquad\qquad \text{Equation 1}$$

Referring to Equation 1, h represents the height 1210 of the magnetoresistive structure, t represents the thickness 1220 of hardmask 140, p represents the pitch 1250, w represents the width 1230 of the magnetoresistive structure, and θ represents minimum etch angle θ. Therefore, if the sum of height 1210 of the magnetoresistive structure and the thickness 1220 of hardmask 140 exceeds the difference of the width 1230 of the magnetoresistive structure from the pitch 1250, the minimum etch angle will be greater than 45°.

As described herein, conventional methods of manufacturing magnetoresistive structures 1100 may include deposition of a hardmask 140 with increased thickness, compared to the methods of manufacturing magnetoresistive structure 1200 described herein. In order to clean sidewalls of a convention magnetoresistive structures 1100 having a reduced pitch, physical etching must be performed at an etch angle θ greater than 45°. Physical etching (e.g., IBE) at angles greater than 45° may cause damage to one or more regions of magnetoresistive structure 1100, 1200. Methods of the present disclosure, including the reduced hardmask 140 thickness, may allow for physically etching sidewalls of magnetoresistive structures 1100, 1200 at an etch angle θ of 45°, without increasing the pitch between adjacent magnetoresistive structures 1100, 1200.

For example, methods of the present disclosure may allow for a 45° IBE to clean the sidewalls of magnetoresistive structures with a width 1230 of approximately 65 nanometers (nm) and a height 1210 of less than or equal to approximately 115 nm, at a pitch 1250 of less than or equal to approximately 180 nm. Conventional manufacturing methods would require increased pitches and/or an increase in the angle θ used to clean the sidewalls of the magnetoresistive structures in order to manufacture magnetoresistive structures with similar dimensions. As another example, methods of the present disclosure may allow for a 45° IBE to clean the sidewalls of magnetoresistive structures with a width 1230 of approximately 40 nm and a height 1210 of less than or equal to approximately 50 nm, at a pitch 1250 of less than or equal to approximately 90 nm. In addition or alternatively, methods of the present disclosure may allow for a 45° IBE to clean the sidewalls of magnetoresistive structures with a width 1230 of approximately 34 nm and a height 1210 of less than or equal to approximately 36 nm, at a pitch 1250 of less than or equal to approximately 70 nm. In some embodiments, the reduced hardmask 140 thickness may be approximately 5 nm to approximately 25 nm, such as, for example, approximately 5 nm to approximately 20 nm, approximately 5 nm to approximately 15 nm, approximately 10 nm to approximately 25 nm, approximately 10 nm to approximately 20 nm, approximately 10 nm to approximately 15 nm, approximately 15 nm to approximately 25 nm, approximately 15 nm to approximately 20 nm, approximately 5 nm, approximately 10 nm, approximately 15 nm, approximately 20 nm, or approximately 25 nm.

In addition to allowing for the improved manufacture of magnetoresistive devices with decreased pitch 1250 between bits (e.g., magnetoresistive structures 1100, 1200), methods of the present disclosure result in bits with improved physical characteristics, compared to conventional methods.

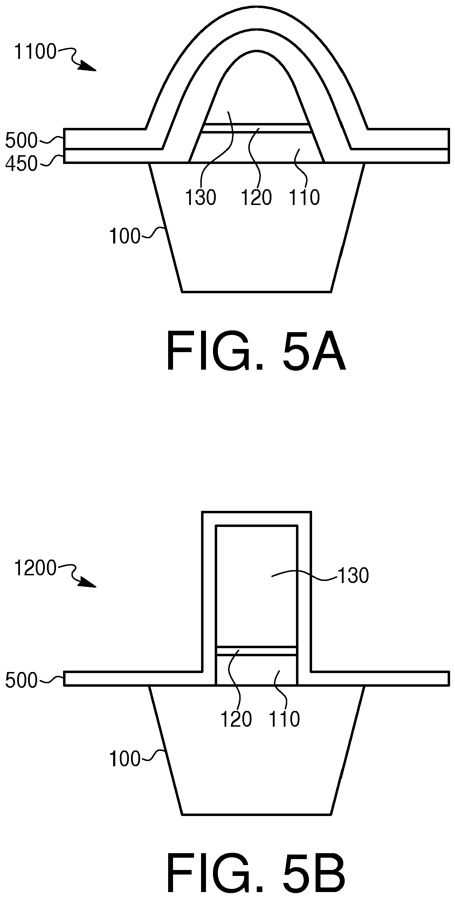

For example, an exemplary profile of a bit manufactured using conventional processes is shown in FIG. 5A, and an exemplary profile of a bit manufactured using methods of the present disclosure, including etching in the presence of a hydrocarbon gas, is shown in FIG. 5B. After magnetoresistive structures 1100, 1200 are formed (e.g., after etching), an encapsulation layer 500 may be formed above magnetoresistive structure 1100, 1200. Referring to FIG. 5A, magnetoresistive structures 1100 manufactured using conventional processes may have a tapered profile due to etching steps using an eroded hardmask 140 as a template. In addition or alternatively, due to the difficulties in cleaning sidewalls of conventionally manufactured magnetoresistive structures 1100, a layer of oxidized material 450 may remain between magnetoresistive structure 1100 and encapsulation layer 500.

Referring to FIG. 5B, magnetoresistive structures 1200 manufactured using methods of the present disclosure may have a rectangular profile. For example, sidewalls of magnetoresistive structures 1200 may be approximately perpendicular to an interface between bottom electrode 110 and via 100. Further, due to the reduced hardmask 140 thickness, sidewall cleaning of the magnetoresistive structure 1200 may be achieved at a 45° etch angle. As a result, a layer of oxidized material 450 may not be present between magnetoresistive structure 1200 and encapsulation layer 500.

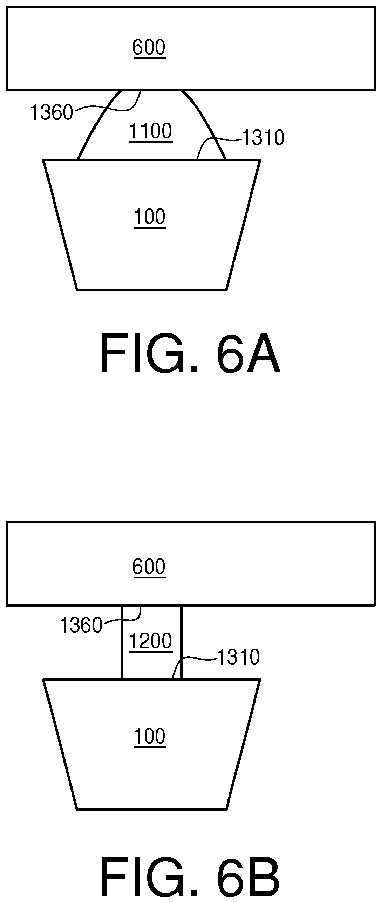

Magnetoresistive devices 1100, 1200 may be formed between a via 100 and an elongate interconnect 600. The elongate interconnect 600 may provide electrical connectivity between magnetoresistive device 1100, 1200 and a bit line, a word line, or other conductor within a magnetoresistive device. The interface of magnetoresistive device 1100, 1200 and elongate interconnect 600 may be referred to as top contact 1360. The interface of magnetoresistive device 1100, 1200 and via 100 may be referred to as bottom contact 1310. Referring to FIG. 6A, the magnetoresistive device 1100 manufactured using conventional methods has a tapered profile due to being etched with an eroded hardmask template. Because of the inherent tapered profile resulting from this type of manufacture, the top contact 1360 of magnetoresistive structure 1100 has a smaller width (e.g., diameter) than the bottom contact 1310 of magnetoresistive structure 1100. Therefore, in order to provide a sufficient width or area of top contact 1360, the width of the bottom of the magnetoresistive stack must be made wider than needed.

Referring to FIG. 6B, the magnetoresistive structure 1200 manufactured using methods of the present disclosure as a rectangular profile where the top contact 1360 has approximately the same width (e.g., diameter) as bottom contact 1310. This allows for an improved connectivity between magnetoresistive structure 1200 and elongate interconnect 600, with a decreased width or area of bottom contact 1310. The area of bottom contact 1310 between magnetoresistive structure 1200 and via 100 may be referred to as the critical dimension. It may be beneficial to reduce the critical dimension without affecting the connectivity between magnetoresistive structure 1200 and elongate interconnect 600. For example, reducing the critical dimension may allow for a higher density of bits, a lower switching energy, an improved signal readout, and/or a reduction in bit-to-bit shorting.

Embodiments described herein and shown in the figures may include a magnetoresistive structure 1100, 1200 above a via 100, where the magnetoresistive structure 1100, 1200 has a width that is less a width of the via 100. In some embodiments, magnetoresistive structure 1100, 1200 has a width that is greater than or equal to a width of the via 100.

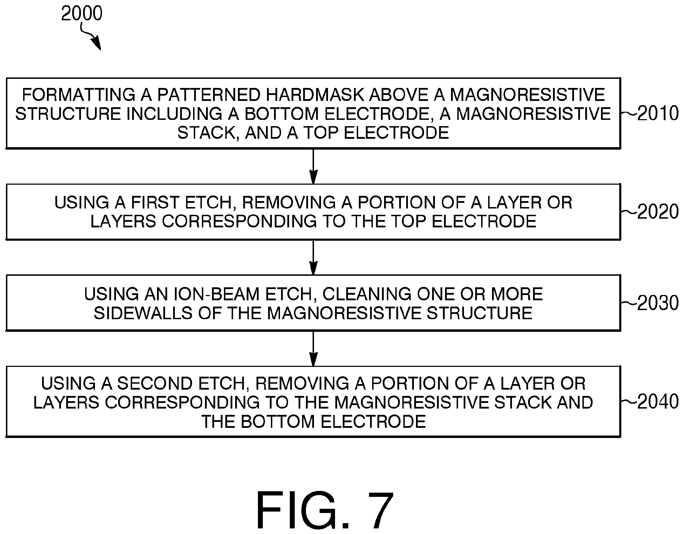

FIG. 7 is a flow chart of a method 2000 of manufacturing a magnetoresistive structure, according to one or more embodiments of the present disclosure. Method 2000 may include forming a patterned hardmask 140 above a magnetoresistive structure 1000 (step 2010). Magnetoresistive structure 1000 may include layers corresponding to a bottom electrode 110, a magnetoresistive stack 120, and a top electrode 130. Method 2000 may include removing a portion of a layer or layers corresponding to the top electrode 130, using a first etch (step 2020). The first etch may be performed in the presence of a hydrocarbon gas 200, wherein the hydrocarbon gas 200 includes a hydrocarbon having a carbon-carbon double bond or a carbon-carbon triple bond. Method 2000 may include cleaning one or more sidewalls of the partially etched magnetoresistive structure 1050, using an ion-beam etch (step 2030). The ion-beam etch may be performed at an angle of approximately 45°. In some embodiments, the ion-beam etch may be performed in the presence of a hydrocarbon gas 200, wherein the hydrocarbon gas 200 includes a hydrocarbon having a carbon-carbon double bond or a carbon-carbon triple bond. Method 2000 may include removing a portion of a layer or layers corresponding to the magnetoresistive stack 120 and bottom electrode 110, using a second etch (step 2040). The second etch may be performed in the presence of a hydrocarbon gas 200, wherein the hydrocarbon gas 200 includes a hydrocarbon having a carbon-carbon double bond or a carbon-carbon triple bond.

Although various embodiments of the present disclosure have been illustrated and described in detail, it will be readily apparent to those skilled in the art that various modifications may be made without departing from the present disclosure.

## Claims

1. A method of manufacturing a magnetoresistive device, the method comprising:

forming a bottom electrode, a magnetoresistive stack, and a top electrode above a via;

removing at least a portion of the top electrode using a first etch; and

removing at least a portion of the magnetoresistive stack and the bottom electrode using a second etch, wherein the first etch, the second etch, or both, is performed in the presence of a gas comprising a hydrocarbon including a carbon-carbon double bond or a carbon-carbon triple bond.

2. The method of claim 1, further comprising, after forming the bottom electrode, the magnetoresistive stack, and the top electrode, and prior to the first etch, depositing a hardmask above the top electrode, wherein the hardmask comprises silicon dioxide, carbon doped silicon dioxide, spin on glass, SiCOH, SiCNH, tetraethyl orthosilicate, spin on carbon, or a combination thereof.

3. The method of claim 1 or claim 2, wherein the hydrocarbon comprises ethylene, ethyne, propylene, propyne, butene, butyne, or a combination thereof.

4. The method of any one of claims 1-3, wherein the gas further comprises a carrier gas.

5. The method of claim 4, wherein a molar ratio of the hydrocarbon to the carrier gas is approximately 1:1 to approximately 1:10.

6. The method of any one of claims 1-5, wherein the first etch is a reactive ion etch.

7. The method of claim 6, wherein the first etch is performed in the presence of a gas comprising a hydrocarbon including a carbon-carbon double bond or a carbon-carbon triple bond, and the gas further comprises a reactive component including argon, oxygen, carbon tetrafluoride, chlorine, water, hydrogen, nitrogen, ammonia, fluoroform, sulfur hexafluoride, one or more fluorocarbons having a formula of $C_xF_y$, or a combination thereof.

8. The method of any one of claims 1-7, further comprising depositing an encapsulation layer above the top electrode.

9. A method of manufacturing a magnetoresistive device, the method comprising:

providing a magnetoresistive structure comprising a bottom electrode, a magnetoresistive stack, and a top electrode;

removing at least a portion of the top electrode using a first etch, wherein the first etch is performed in the presence of a first gas mixture;

using an ion-beam etch to clean a sidewall of the magnetoresistive structure, wherein the ion-beam etch is performed in the presence of a second gas mixture; and

removing at least a portion of the magnetoresistive stack and the bottom electrode using a second etch, wherein the second etch is performed in the presence of a third gas mixture;

wherein the first, second, and third gas mixtures comprise a hydrocarbon including a carbon-carbon double bond or a carbon-carbon triple bond.

10. The method of claim 9, wherein the magnetoresistive structure is a first magnetoresistive structure, and a pitch between the first magnetoresistive structure and a second magnetoresistive structure adjacent to the first magnetoresistive structure is less than or equal to approximately 180 nanometers.

11. The method of claim 9, wherein a height of the magnetoresistive structure is less than or equal to approximately 115 nanometers.

12. The method of claim 9, wherein the magnetoresistive structure is above a via, and a width of magnetoresistive structure is less than a width of via.

13. The method of claim 9, wherein a polymerization layer forms during the first etch.

14. The method of claim 13, wherein the polymerization layer is disposed on one or more sidewalls of a hardmask and a top surface of a layer constituting the top electrode.

15. The method of claim 14, further comprising depositing an encapsulation layer in contact with the top electrode.

FIG. 1

FIG. 2A

FIG. 2B

FIG. 2C

1050

140

130

120

110

400

100

400

# FIG. 2D

1100

130

120

110

400

100

400

# FIG. 2E

FIG. 3A

FIG. 3B

1050

<u>140</u>

<u>130</u>

<u>120</u>

<u>110</u>

400

<u>100</u>

400

# FIG. 3C

200

1050

<u>130</u>

250

<u>120</u>

<u>110</u>

400

<u>100</u>

400

# FIG. 3D

1200

130

120

110

400

100

400

# FIG. 3E

1250

1201a

1050a

140a

1220

130a

1230

1210

120a

110a

θ

1201b

1050b

140b

130b

120b

110b

100a

400

100b

# FIG. 4

1100

500
450

130 120 110

100

# FIG. 5A

1200

130

500

120 110

100

# FIG. 5B

FIG. 6A

FIG. 6B

2000

FORMATTING A PATTERNED HARDMASK ABOVE A MAGNORESISTIVE STRUCTURE INCLUDING A BOTTOM ELECTRODE, A MAGNORESISTIVE STACK, AND A TOP ELECTRODE ~2010

USING A FIRST ETCH, REMOVING A PORTION OF A LAYER OR LAYERS CORRESPONDING TO THE TOP ELECTRODE ~2020

USING AN ION-BEAM ETCH, CLEANING ONE OR MORE SIDEWALLS OF THE MAGNORESISTIVE STRUCTURE ~2030

USING A SECOND ETCH, REMOVING A PORTION OF A LAYER OR LAYERS CORRESPONDING TO THE MAGNORESISTIVE STACK AND THE BOTTOM ELECTRODE ~2040

# FIG. 7

Europäisches
Patentamt

European
Patent Office

Office européen
des brevets

**EUROPEAN SEARCH REPORT**

Application Number

EP 24 18 9775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/276657 A1 (JOUBERT OLIVIER [FR] ET AL) 1 November 2012 (2012-11-01) | 1-6,8 | INV. H10N50/01 |
| A | * figures 1, 2A-F * <br> * paragraph [0052] - paragraph [0066] * | 7,9-15 | ADD. H10B61/00 |
| A | US 2002/192976 A1 (TRAPP SHANE J [US] ET AL) 19 December 2002 (2002-12-19) <br> * paragraph [0011] - paragraph [0017] * <br> * paragraph [0040] * | 1-15 | |
| A | US 2014/038311 A1 (KIM JISOO [US] ET AL) 6 February 2014 (2014-02-06) <br> * figures 1, 2 * <br> * paragraph [0030] - paragraph [0058] * | 1-15 | |
| A | CN 110 098 320 A (SHANGHAI CIYU INFORMATION TECH CO LTD) 6 August 2019 (2019-08-06) <br> * paragraph [0041] - paragraph [0052]; figure 4 * | 1-15 | |

TECHNICAL FIELDS
SEARCHED       (IPC)

H10N
H10B

The present search report has been drawn up for all claims

| Place of search | Date of completion of the search | Examiner |
|---|---|---|
| Munich | 20 November 2024 | Krohns, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 9775

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2024

| Patent document cited in search report | Publication date | Patent family member(s) | Publication date |
|---|---|---|---|
| US 2012276657 A1 | 01-11-2012 | NONE | |
| US 2002192976 A1 | 19-12-2002 | US 6451705 B1<br>US 2002192976 A1 | 17-09-2002<br>19-12-2002 |
| US 2014038311 A1 | 06-02-2014 | NONE | |
| CN 110098320 A | 06-08-2019 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63514876
- US 8686484 B
- US 8747680 B
- US 9023219 B
- US 9136464 B
- US 9412786 B
- US 9419208 B
- US 9722174 B
- US 10461251 B
- US 10483460 B
- US 10700268 B
- US 10847711 B
- US 10950657 B